(19) Europäisches Patentamt

European Patent Office

Office européen des brevets

(11) Veröffentlichungsnummer: **0 524 442 B1**

(12) **EUROPÄISCHE PATENTSCHRIFT**

(45) Veröffentlichungstag der Patentschrift: **11.10.95**

(51) Int. Cl.⁶: **C04B 35/00**, H01L 39/24

(21) Anmeldenummer: **92110538.3**

(22) Anmeldetag: **23.06.92**

(54) **Hochtemperatur-Supraleiter und Verfahren zu seiner Herstellung.**

(30) Priorität: **26.07.91 DE 4124823**

(43) Veröffentlichungstag der Anmeldung:
**27.01.93 Patentblatt 93/04**

(45) Bekanntmachung des Hinweises auf die
Patenterteilung:
**11.10.95 Patentblatt 95/41**

(84) Benannte Vertragsstaaten:
**AT BE CH DE ES FR GB GR IT LI LU NL SE**

(56) Entgegenhaltungen:
**EP-A- 0 334 517**
**EP-A- 0 362 492**

**DATABASE WPIL Week 8931, Derwent Publications Ltd., London, GB; AN 89-224405 & JP-A-1 160 861 (MITSUBISHI DENKI KK) 23. Juni 1989**

(73) Patentinhaber: **HOECHST AKTIENGESELL-SCHAFT**

**D-65926 Frankfurt am Main (DE)**

(72) Erfinder: **Bock, Joachim, Dr.**
**Am Burgfeld 51**
**W-5042 Erftstadt (DE)**
Erfinder: **Preisler, Eberhard, Dr.**
**Bertolt-Brecht-Strasse 55**
**W-5042 Erftstadt (DE)**

EP 0 524 442 B1

**Beschreibung**

Die vorliegende Erfindung betrifft einen aus den Oxiden des Bismuts, Strontiums, Calciums, Kupfers und gegebenenfalls des Bleis bestehenden Hochtemperatur-Supraleiter sowie ein Verfahren zu seiner Herstellung.

Aus der US-PS 5 047 391 ist ein Verfahren zur Herstellung eines Hochtemperatursupraleiters der Zusammensetzung $Bi_2(Sr,Ca)_3Cu_2O_x$ mit Werten für x von 8 bis 10 bekannt. Dabei werden stöchiometrische Mischungen der Oxide oder Carbonate von Bismut, Strontium, Calcium und Kupfer auf Temperaturen von 870 bis 1100°C unter Bildung einer homogenen Schmelze erhitzt. Diese Schmelze wird in Kokillen vergossen und erstarrt darin. Die aus den Kokillen entnommenen Gußkörper werden 6 bis 30 Stunden lang bei 780 bis 850°C getempert und anschließend mindestens 6 Stunden bei 600 bis 830°C in Sauerstoffatmosphäre behandelt. Auf diese Weise lassen sich Formkörper als Plättchen mit bis zu mehreren cm Kantenlänge bzw. Durchmesser sowie als Stäbe mit bis zu 50 cm Länge und 12 mm Durchmesser herstellen, welche jeweils aus einer phasenreinen Verbindung bestehen.

Für Formkörper der genannten Art gibt es eine Reihe von Anwendungen im elektrotechnischen Bereich, beispielsweise als Stromzuführungen für Leistungsübertragungen, als Strombegrenzer sowie in Form von magnetischen Abschirmungen. Voraussetzung für den technischen Einsatz ist jedoch, daß der Hochtemperatur-Supraleiter bei der Temperatur des flüssigen Stickstoffs (77 K) eine kritische Stromdichte von etwa 1000 A/cm$^2$ aufweist.

Bekannte Bänder von 1 cm Breite und 15 $\mu$m Dicke aus $Bi_2Sr_2CaCu_2O_x$ auf Silbersubstrat weisen zwar eine kritische Stromdichte von 10000 A/cm$^2$ auf; solche Bänder können jedoch nur einen Absolutstrom von 15 A tragen (vergl. "Proceedings of the ICMC '90 Topical Conference on Material Aspects of High-Temperature Superconductors", 1991, Seiten 165 bis 176). Noch geringer sind die Absolutströme bei Dünnfilmen, die überdies bisher nur in Abmessungen von wenigen cm hergestellt werden können.

Für Massivteile aus Hochtemperatur-Supraleiter-Material auf der Grundlage der Oxide von Bismut, Strontium, Calcium und Kupfer sind bei 77 K Stromdichten in der Größenordnung von 10$^2$ A/cm$^2$ gemessen worden.

Es ist Aufgabe der vorliegenden Erfindung, einen Hochtemperatur-Supraleiter auf der Basis der Oxide des Bismuts, Strontiums, Calciums, Kupfers und gegebenenfalls des Bleis sowie ein Verfahren zu seiner Herstellung anzugeben, wobei der Hochtemperatur-Supraleiter bei 77 K eine kritische Stromdichte von mindestens 1000 A/cm$^2$ aufweist und einen Absolutstrom von mindestens 100 A tragen kann. Der erfindungsgemäße Hochtemperatur-Supraleiter besteht aus den Oxiden des Bismuts, Strontiums, Calciums, Kupfers und gegebenenfalls des Bleis der Zusammensetzung $Bi_{2-a+b+c}Pb_a(Sr, Ca)_{3-b-c}Cu_{2+d}O_x$ mit a = 0 bis 0,7; b + c = 0 bis 0,5; d = - 0,1 bis 0,1; x = 7 bis 10 und einem Verhältnis von Sr : Ca von 2,8 : 1 bis 1 : 2,8 sowie aus Sulfaten von Strontium und/oder Barium.

Der Hochtemperatur-Supraleiter gemäß der Erfindung kann auch noch dadurch weitergebildet sein, daß

a) a = 0; b + c = 0,25; d = 0 und x = 7,9 bis 8,5 ist sowie das Verhältnis von Sr : Ca von 2,2 : 1 bis 1,5 : 1 beträgt;

b) sein Strontiumsulfat-Gehalt 0,1 bis 30 Gewichts%, vorzugsweise 3 bis 10 Gewichts%, beträgt;

c) sein Bariumsulfat-Gehalt 0,1 bis 20 Gewichts%, vorzugsweise 3 bis 10 Gewichts%, beträgt.

Ein Verfahren zur Herstellung des erfindungsgemäßen Hochtemperatur-Supraleiters kann dadurch gekennzeichnet sein, daß man die Oxide des Bismuts, Strontiums, Calciums und Kupfers und gegebenenfalls des Bleis mit den Sulfaten des Strontiums und/oder Bariums innig vermischt, daß man die Mischung durch Erhitzen auf Temperaturen von 870 bis 1300°C, vorzugsweise von 900 bis 1100°C, aufschmilzt, wobei höhere Gehalte an den Sulfaten von Strontium und/oder Barium höhere Temperaturen erfordern, daß man die Schmelze in Kokillen abgießt und darin langsam erstarren läßt, und daß man die aus den Kokillen entnommenen Formkörper bei Temperaturen von 700 bis 900°C, vorzugsweise 750 bis 870°C, in sauerstoffhaltiger Atmosphäre glüht.

Dieses Verfahren kann auch noch dadurch ausgestaltet sein, daß

d) man die Schmelze in einen waagerecht angeordneten, um seine Längsachse rotierenden Zylinder abgießt;

e) man die Schmelze in Kokillen aus Quarz abgießt;

f) man die Schmelze in Kokillen aus Kupfer abgießt;

g) man die Formkörper zur Glühbehandlung bis 700°C mit 250 bis 350°C/h schnell und darüber mit 5 bis 20°C/h langsam aufheizt;

h) man in einer Atmosphäre aus Luft und Stickstoff im Volumenverhältnis 1 : 1 glüht;

i) man in reinem Sauerstoff glüht.

2

Wenn der erfindungsgemäße Hochtemperatur-Supraleiter aus einem Gemisch der sog. 2-Schichtverbindung (Oxide des Bismuts, Strontiums, Calciums und Kupfers im stöchiometrischen Verhältnis der Metalle von 2 : 2 : 1 : 2) und Strontiumsulfat besteht, sind Zersetzungsprodukte oder andere Phasen bis zu einem Strontiumsulfatgehalt von 30 Gewichts% nicht nachweisbar.

Der aus der sog. 2-Schichtverbindung und Bariumsulfat bestehende Hochtemperatur-Supraleiter gemäß der Erfindung hingegen enthält Erdalkalicuprat-Phasen, beispielsweise $(Sr,Ca)CuO_2$.

Aus thermoanalytischen Untersuchungen ergibt sich, daß die Erdalkalisulfate mit den Oxiden des Bismuts, Strontiums, Calciums, Kupfers und gegebenenfalls des Bleis unter Bildung von Eutektika aufschmelzen. Die Schmelzpunkte von Bariumsulfat und Strontiumsulfat liegen nämlich mit 1580 bzw. 1600°C wesentlich höher.

Schließlich zeigen keramographische Untersuchungen und Aufnahmen mit dem Rasterelektronenmikroskop, daß in den Hochtemperatur-Supraleitern gemäß der Erfindung Ausscheidungen von Strontiumsulfat und Bariumsulfat im Größenbereich von 10 bis 100 $\mu$m vorliegen.

Überraschenderweise wurde gefunden, daß bei den erfindungsgemäßen Hochtemperatur-Supraleitern die Sprungtemperatur mit steigendem Gehalt an Erdalkalisulfaten nicht nur nicht abnimmt, sondern in einigen Fällen sogar noch ansteigt.

Die kritische Stromdichte der Hochtemperatur-Supraleiter gemäß der Erfindung ist mit Werten um ca. 1400 A/cm$^2$ bei 77 K um ein Vielfaches größer als von Hochtemperatur-Supraleitern nach dem Stand der Technik.

Biegebruchfestigkeit und Elastizitätsmodul der erfindungsgemäßen Hochtemperatur-Supraleiter weisen befriedigende Werte auf.

Hochtemperatur-Supraleiter gemäß der Erfindung können als größere Formkörper, beispielsweise Stangen, Platten oder Zylinder hergestellt werden, weil sie weniger spröde sind und bei ihnen die Tendenz zur Rißbildung geringer ist als bei Formkörpern nach dem Stand der Technik. Dies gilt sowohl bei der Erstarrung der Schmelze als auch bei der Glühbehandlung der Formkörper.

Beispiel 1 (Vergleichsbeispiel)

Binäre Oxide des Bismuts, Strontiums, Calciums und Kupfers im stöchiometrischen Verhältnis der Metalle von 2 : 2 : 1 : 2 wurden intensiv gemischt. 1,8 kg dieser Mischung wurden in einem Korundtiegel bei 1000°C in eine homogene Schmelze überführt. Die homogene Schmelze wurde über eine Rinne in eine waagerecht angeordnete, um ihre Längsachse rotierende zylindrische Kokille von 200 mm Durchmesser und 100 mm Tiefe vergossen, wobei sich die Schmelze infolge der Fliehkraft gleichmäßig an der Kokillenwand verteilte. Um eine langsamere Abkühlung zu ermöglichen, wurde direkt nach dem Vergießen ein auf 600°C vorgeheizter Rohrofen über die Kokille geschoben. Der Ofen wurde mit etwa 2°C/min auf Raumtemperatur abgekühlt. Der nach dem Abkühlen des Rohrofens in der Kokille befindliche Hohlzylinder wies, vermutlich auf Grund starker Eigenspannungen, zwei gegenüberliegende, senkrecht verlaufende Risse auf und zerbrach beim Entnehmen aus der Kokille in zwei Teile.

Beispiel 2 (Vergleichsbeispiel)

Beispiel 1 wurde mit der Änderung wiederholt, daß nur 1,5 kg Mischung in eine homogene Schmelze überführt wurde. Der nach dem Abkühlen des Rohrofens aus der Kokille entnommene Hohlzylinder wies an seinem oberen und unteren Rand jeweils zwei gegenüberliegende Querrisse von ca. 1 cm Länge auf.

Der Hohlzylinder wurde einer Glühbehandlung (24 Stunden bei 750°C; 120 Stunden bei 850°C) unterworfen. Danach hatten sich an den Enden der Querrisse auch Längsrisse gebildet, die das Wegplatzen einzelner Ringsegmente zur Folge hatten.

Beispiel 3 (gemäß der Erfindung)

Beispiel 1 wurde mit den Änderungen wiederholt, daß die binären Oxide gemeinsam mit 10 Gewichts% Strontiumsulfat intensiv gemischt wurden und daß 2 kg dieser Mischung durch Erhitzen auf 1050°C in eine homogene Schmelze überführt wurden.

Der Kokille wurde ein massiver, rißfreier Hohlzylinder mit einer Wandstärke von etwa 5 mm entnommen.

Der Hohlzylinder wurde einer Glühbehandlung (24 Stunden bei 750°C; 120 Stunden bei 850°C) unterworfen. Auch danach war der Hohlzylinder rißfrei und zeigte keinerlei Ausschmelzungen.

Beispiel 4 (gemäß der Erfindung)

Eine Mischung nach Beispiel 3 wurde aufgeschmolzen und in einseitig geschlossene Quarzrohre (innerer Durchmesser: 8 mm) mit Längen von 100, 150, 200, 300 und 500 mm vergossen. Nach den Abkühlen auf Raumtemperatur konnte die erstarrte Schmelze allen Quarzrohren in Form von kompakten Stäben ohne sichtbare Risse entnommen werden.

Die Stäbe wurden in einem Luft/Stickstoff-Gemisch (Volumenverhältnis 1 : 1) mit Geschwindigkeiten von 300°C/h auf 700°C und mit 10°C/h auf 850°C aufgeheizt und dabei 60 Stunden belassen. Die Glühbehandlung erfolgte zur Gewährleistung eines möglichst homogenen Temperaturfeldes in einen Mehrzonenrohrofen.

Alle dem Ofen nach Abkühlung entnommenen Stäbe waren rißfrei.

Der Stab von 200 mm Länge wurde mit Kontakten versehen und mit Hilfe einer Vierpunktmessung die kritische Stromdichte bei 77 K zu 570 A/cm$^2$ (Kriterium: 1 $\mu$V/cm) ermittelt, wobei der Abstand der Spannungskontakte 13 cm betrug.

Die temperaturabhängige Bestimmung des Widerstandes ergab den vollkommenen Widerstandsverlust bei 89,5 K.

Beispiel 5 (Vergleichsbeispiel)

Eine Mischung nach Beispiel 1 wurde aufgeschmolzen und in die verschiedenen einseitig geschlossenen Quarzrohre gemäß Beispiel 4 vergossen.

Nach den Abkühlen auf Raumtemperatur konnten nur aus den 100 und 150 mm langen Quarzrohren jeweils ein kompakter Stab entnommen werden, während die übrigen Quarzrohre nur Bruchstücke enthielten.

Beispiel 6 (gemäß der Erfindung)

Binäre Oxide des Bismuts, Strontiums, Calciums und Kupfers im stöchiometrischen Verhältnis der Metalle von 2 : 2 : 1 : 2 wurden mit unterschiedlichen Mengen Strontiumsulfat (0, 3, 6, 10, 15, 20, 25 und 30 Gewichts%) intensiv gemischt. Die unterschiedlichen Mischungen wurden in einem Korundtiegel bei 1000°C (bis zu 10 % SrSO$_4$), 1030°C (bis zu 20 % SrSO$_4$) und 1100°C (bis zu 30 % SrSO$_4$) in homogene Schmelzen überführt, welche jeweils in oben offene, rechteckige Kupferkokillen der Abmessungen 15 x 15 x 60 mm$^3$ vergossen wurden. Die Abkühlung der Schmelzen wurde dadurch verlangsamt, daß die Kokillen direkt nach dem Vergießen in einen auf 600°C vorgeheizten Kammerofen gestellt wurden, der dann ausgeschaltet wurde.

Aus den erhaltenen Formkörpern wurden mit Hilfe einer Diamanttrennscheibe scheibenförmige Proben von jeweils 4 mm Dicke und Stäbchen der Abmessungen 45 x 4 x 3 mm$^3$ herausgeschnitten. Alle Proben und Stäbchen wurden gemeinsam in einem Kammerofen in Luft 24 Stunden bei 850°C geglüht.

Aus den scheibenförmigen Proben wurden Stäbchen von 1 mm$^2$ Querschnitt und etwa 10 mm Länge herausgesägt. An diesen Stäbchen wurden die Sprungtemperaturen Tc und die kritische Stromdichte jc bestimmt, während die Stäbchen der Abmessungen 45 x 4 x 3 mm$^3$ zur Bestimmung der Biegebruchfestigkeit und des Elastizitätsmoduls (E-Moduls) dienten.

Die Ergebnisse sind in der folgenden Tabelle zusammengefaßt:

| Gew% SrSO$_4$ | Tc [K] | R = 0 [K] | jc [A/cm$^2$] | Biegebruchfestigkeit [MPa] | E-Modul [GPa] |
|---|---|---|---|---|---|
| 0 | 88 | 85,5 | 84 | 27 | 31 |
| 3 | 93 | 89,5 | 1386 | 28 | 35 |
| 6 | 92 | 89,5 | 1102 | 25 | 32 |
| 10 | 92 | 89,5 | 608 | 30 | 36 |
| 15 | 93 | 88,5 | 623 | 33 | 43 |
| 20 | 92 | 88,5 | 307 | 31 | 39 |
| 30 | 92 | 89 | 124 | | |

Beispiel 7 (gemäß der Erfindung)

Beispiel 6 wurde mit der Änderung wiederholt, daß anstelle von Strontiumsulfat Bariumsulfat eingesetzt wurde.

Die Ergebnisse sind in der folgenden Tabelle zusammengefaßt:

| Gew% $BaSO_4$ | Tc [K] | R = 0 [K] | jc [A/cm$^2$] |
|---|---|---|---|
| 0 | 91 | 88 | 101 |
| 3 | 95 | 91,5 | 629 |
| 6 | 94 | 91 | 570 |
| 10 | 93 | 90,5 | 309 |
| 15 | 87 | 83,5 | 136 |
| 20 | 86 | 83,5 | 75 |

Beispiel 8 (Vergleichsbeispiel)

Beispiel 6 wurde mit der Änderung wiederholt, daß anstelle von Strontiumsulfat Calciumsulfat (wasserfrei) eingesetzt wurde.

Die Ergebnisse sind in der folgenden Tabelle zusammengefaßt:

| Gew% $CaSO_4$ | Tc [K] | R = 0 [K] | jc [A/cm$^2$] |
|---|---|---|---|
| 0 | 88 | 85,5 | 96 |
| 0,7 | 89 | 86,5 | 159 |
| 2,2 | 91 | 88,5 | 56 |
| 4,4 | 89 | 86,5 | 1 |
| 7,4 | 85 | 82,5 | < 1 |
| 11,1 | 82 | 67 | < 1 |

Bereits ab 4,4 Gew% $CaSO_4$ sind im Röntgendiagramm neben der sog. Zweischichtverbindung eine Reihe von Fremdphasen erkennbar.

**Patentansprüche**
**Patentansprüche für folgende Vertragsstaaten : AT, BE, CH, DE, FR, GB, GR, IT, LI, LU, NL, SE**

1. Aus den Oxiden des Bismuts, Strontiums, Calciums und Kupfers und gegebenenfalls des Bleis der Zusammensetzung $Bi_{2-a+b+c}$ $Pb_a$ $(Sr, Ca)_{3-b-c}$ $Cu_{2+d}$ $O_x$ mit a = 0 bis 0,7; b + c = 0 bis 0,5; d = -0,1 bis 0,1; x = 7 bis 10 und einem Verhältnis von Sr : Ca von 2,8 : 1 bis 1 : 2,8 sowie aus mindestens 0,1 Gewichts% Strontiumsulfat und/oder mindestens 0,1 Gewichts% Bariumsulfat bestehender Hochtemperatur-Supraleiter.

2. Hochtemperatur-Supraleiter nach Anspruch 1, dadurch gekennzeichnet, daß a = 0; b + c = 0,25; d = 0 und x = 7,9 bis 8,5 ist sowie das Verhältnis von Sr : Ca von 2,2 : 1 bis 1,5 : 1 beträgt.

3. Hochtemperatur-Supraleiter nach Anspruch 1 oder 2, dadurch gekennzeichnet, daß sein Strontiumsulfat-Gehalt bis zu 30 Gewichts%, vorzugsweise 3 bis 10 Gewichts%, beträgt.

4. Hochtemperatur-Supraleiter nach mindestens einem der Ansprüche 1 bis 3, dadurch gekennzeichnet, daß sein Bariumsulfat-Gehalt bis zu 20 Gewichts%, vorzugsweise 3 bis 10 Gewichts%, beträgt.

5. Verfahren zur Herstellung des Hochtemperatur-Supraleiters nach mindestens einem der Ansprüche 1 bis 4, dadurch gekennzeichnet, daß man die Oxide des Bismuts, Strontiums, Calciums und Kupfers und gegebenenfalls des Bleis mit den Sulfaten des Strontiums und/oder Bariums innig vermischt, daß man die Mischung durch Erhitzen auf Temperaturen von 870 bis 1300 °C, vorzugsweise von 900 bis 1100 °C, aufschmilzt, wobei höhere Gehalte an den Sulfaten von Strontium und/oder Barium höhere Temperaturen erfordern, daß man die Schmelze in Kokillen abgießt und darin langsam erstarren läßt, und daß man die aus den Kokillen entnommenen Formkörper bei Temperaturen von 700 bis 900 °C, vorzugsweise 750 bis 870 °C, in sauerstoffhaltiger Atmosphäre glüht.

6. Verfahren nach Anspruch 5, dadurch gekennzeichnet, daß man die Schmelze in einen waagerecht angeordneten, um seine Längsachse rotierenden Zylinder abgießt.

7. Verfahren nach Anspruch 5 oder 6, dadurch gekennzeichnet, daß man die Schmelze in Kokillen aus Quarz abgießt.

8. Verfahren nach Anspruch 5 oder 6, dadurch gekennzeichnet, daß man die Schmelze in Kokillen aus Kupfer abgießt.

9. Verfahren nach mindestens einem der Ansprüche 5 bis 8, dadurch gekennzeichnet, daß man die Formkörper zur Glühbehandlung bis 700 °C mit 250 bis 350 °C/h schnell und darüber mit 5 bis 20 °C/h langsam aufheizt.

10. Verfahren nach mindestens einem der Ansprüche 5 bis 9, dadurch gekennzeichnet, daß man in einer Atmosphäre aus Luft und Stickstoff im Volumenverhältnis 1 : 1 glüht.

11. Verfahren nach mindestens einem der Ansprüche 5 bis 9, dadurch gekennzeichnet, daß man in reinem Sauerstoff glüht.

**Patentansprüche für folgenden Vertragsstaat : ES**

1. Verfahren zur Herstellung eines aus den Oxiden des Bismuts, Strontiums, Calciums und Kupfers und gegebenenfalls des Bleis der Zusammensetzung $Bi_{2-a+b+c}$ $Pb_a$ $(Sr, Ca)_{3-b-c}$ $Cu_{2+d}$ $O_x$ mit a = 0 bis 0,7; b + c = 0 bis 0,5; d = -0,1 bis 0,1; x = 7 bis 10 und einem Verhältnis von Sr: Ca von 2,8 : 1 bis 1 : 2,8 bestehenden Hochtemperatur-Supraleiters, dadurch gekennzeichnet, daß man die Oxide des Bismuts, Strontiums, Calciums und Kupfers und gegebenenfalls des Bleis mit einer solchen Menge der Sulfate des Strontiums und/oder Bariums innig vermischt, daß der resultierende Hochtemperatur-Supraleitermindestens 0,1 Gewichts% Strontiumsulfat und/oder mindestens 0,1 Gewichts% Bariumsulfat enthält, daß man die Mischung durch Erhitzen auf Temperaturen von 870 bis 1300 °C, vorzugsweise von 900 bis 1100 °C, aufschmilzt, wobei höhere Gehalte an den Sulfaten von Strontium und/oder Barium höhere Temperaturen erfordern, daß man die Schmelze in Kokillen abgießt und darin langsam erstarren laßt, und daß man die aus den Kokillen entnommenen Formkörper bei Temperaturen von 700 bis 900 °C, vorzugsweise 750 bis 870 °C, in sauerstoffhaltiger Atmosphäre glüht.

2. Verfahren nach Anspruch 1, dadurch gekennzeichnet, daß der Strontiumsulfat-Gehalt des Hochtemperatur-Supraleiters bis zu 30 Gewichts%, vorzugsweise 3 bis 10 Gewichts%, beträgt.

3. Verfahren nach Anspruch 1 oder 2, dadurch gekennzeichnet, daß der Bariumsulfat-Gehalt des Hochtemperatur-Supraleiters bis zu 20 Gewichts%, vorzugsweise 3 bis 10 Gewichts%, beträgt.

4. Verfahren nach mindestens einem der Ansprüche 1 bis 3, dadurch gekennzeichnet, daß man die Schmelze in einen waagerecht angeordneten, um seine Längsachse rotierenden Zylinder abgießt.

5. Verfahren nach mindestens einem der Ansprüche 1 bis 3, dadurch gekennzeichnet, daß man die Schmelze in Kokillen aus Quarz abgießt.

6. Verfahren nach mindestens einem der Ansprüche 1 bis 3, dadurch gekennzeichnet, daß man die Schmelze in Kokillen aus Kupfer abgießt.

7. Verfahren nach mindestens einem der Ansprüche 1 bis 6, dadurch gekennzeichnet, daß man die Formkörper zur Glühbehandlung bis 700 °C mit 250 bis 350 °C/h schnell und darüber mit 5 bis 20 °C/h langsam aufheizt.

8.  Verfahren nach mindestens einem der Ansprüche 1 bis 7, <u>dadurch gekennzeichnet</u>, daß man in einer Atmosphäre aus Luft und Stickstoff im Volumenverhältnis 1 : 1 glüht.

9.  Verfahren nach mindestens einem der Ansprüche 1 bis 7, <u>dadurch gekennzeichnet</u>, daß man in reinem Sauerstoff glüht.

**Claims**
**Claims for the following Contracting States : AT, BE, CH, DE, FR, GB, GR, IT, LI, LU, NL, SE**

1.  A high-temperature superconductor composed of the oxides of bismuth, strontium, calcium, copper and, optionally, of lead, having the composition $Bi_{2-a+b+c}$ $Pb_a$ (Sr, Ca)$_{3-b-c}$ $Cu_{2+d}$ $O_x$ where a = 0 to 0.7; b + c = 0 to 0.5; d = - 0.1 to 0.1 and x = 7 to 10, and a Sr:Ca ratio of 2.8:1 to 1:2.8, and of at least 0.1 % by weight strontium sulfate and/or at least 0.1 % by weight barium sulfate.

2.  The high-temperature superconductor as claimed in claim 1, wherein a = 0; b + c = 0.25; d = 0 and x = 7.9 to 8.5 and the Sr:Ca ratio is from 2.2:1 to 1.5:1.

3.  The high-temperature superconductor as claimed in claim 1 or 2, wherein its strontium sulfate content is up to 30 % by weight, preferably 3 to 10 % by weight.

4.  The high-temperature superconductor as claimed in at least one of claims 1 to 3, wherein its barium sulfate content is up to 20 % by weight, preferably 3 to 10 % by weight.

5.  A process for the preparation of the high-temperature superconductor as claimed in at least one of claims 1 to 4, which comprises intimately mixing the oxides of bismuth, strontium, calcium, copper and, optionally, of lead, with strontium and/or barium sulfates, melting the mixture by heating to temperatures of 870 to 1300°C, preferably of 900 to 1100°C, higher temperatures being required for higher contents of strontium and/or barium sulfate, pouring the melt into molds and allowing it to solidify slowly therein and subjecting the moldings removed from the molds to a heat treatment at temperatures of 700 to 900°C, preferably 750 to 870°C, in an oxygen-containing atmosphere.

6.  The process as claimed in claim 5, wherein the melt is poured into a horizontally arranged cylinder rotating about its longitudinal axis.

7.  The process as claimed in claim 5 or 6, wherein the melt is poured into molds made of quartz.

8.  The process as claimed in claim 5 or 6, wherein the melt is poured into molds made of copper.

9.  The process as claimed in at least one of claims 5 to 8, wherein for the heat treatment, the moldings are heated rapidly at 250 to 350°C/h up to 700°C and above this temperature are heated slowly at 5 to 20°C/h.

10. The process as claimed in at least one of claims 5 to 9, wherein the heat treatment is carried out in an atmosphere of air and nitrogen in the ratio by volume of 1:1.

11. The process as claimed in at least one of claims 5 to 9, wherein the heat treatment is carried out in pure oxygen.

**Claims for the following Contracting State : ES**

1.  A process for the preparation of a high-temperature superconductor composed of the oxides of bismuth, strontium, calcium, copper and, optionally, of lead, having the composition $Bi_{2-a+b+c}$ $Pb_a$ (Sr, Ca)$_{3-b-c}$ $Cu_{2+d}$ $O_x$ where a = 0 to 0.7; b + c = 0 to 0.5; d = - 0.1 to 0.1 and x = 7 to 10, and a Sr:Ca ratio of 2.8:1 to 1:2.8, which comprises intimately mixing the oxides of bismuth, strontium, calcium, copper and, optionally, of lead, with such an amount of strontium and/or barium sulfates, that the resulting high-temperature superconductor contains at least 0.1 % by weight strontium sulfate and/or at least 0.1 % by weight barium sulfate, melting the mixture by heating to temperatures of 870 to 1300°C, preferably of 900 to 1100°C, higher temperatures being required for higher contents of strontium and/or barium sulfate, pouring the melt into molds and allowing it to solidify slowly therein and subjecting the moldings removed from the molds to a heat treatment at temperatures of 700 to 900°C, preferably 750 to 870°C, in an oxygen-containing atmosphere.

2. The process as claimed in claim 1, wherein the strontium sulfate content of the high-temperature superconductor is up to 30 % by weight, preferably 3 to 10 % by weight.

3. The process as claimed in claim 1 or 2, wherein the barium sulfate content of the high-temperature superconductor is up to 20 % by weight, preferably 3 to 10 % by weight.

4. The process as claimed in at least one of claims 1 to 3, wherein the melt is poured into a horizontally arranged cylinder rotating about its longitudinal axis.

5. The process as claimed in at least one of claims 1 to 3, wherein the melt is poured into molds made of quartz.

6. The process as claimed in at least one of claims 1 to 3, wherein the melt is poured into molds made of copper.

7. The process as claimed in at least one of claims 1 to 6, wherein for the heat treatment, the moldings are heated rapidly at 250 to 350°C/h up to 700°C and above this temperature are heated slowly at 5 to 20°C/h.

8. The process as claimed in at least one of claims 1 to 7, wherein the heat treatment is carried out in an atmosphere of air and nitrogen in the ratio by volume of 1:1.

9. The process as claimed in at least one of claims 1 to 7, wherein the heat treatment is carried out in pure oxygen.

**Revendications**
**Revendications pour les Etats contractants suivants : AT, BE, CH, DE, FR, GB, GR, IT, LI, LU, NL, SE**

1. Conducteur haute température composé d'oxydes de bismuth, de strontium, de calcium et de cuivre et le cas échéant de plomb, de composition $Bi_{2-a+b+c} Pb_a (Sr, Ca)_{3-b-c} Cu_{2+d} O_x$ où $a = 0$ à $0,7$ ; $b + c = 0$ à $0,5$ ; $d = -0,1$ à $0,1$; $x = 7$ à $10$ et le rapport Sr : Ca est de $2,8 : 1$ à $1 : 2,8$, ainsi que d'au moins 0,1 % en poids de sulfate de strontium et/ou au moins 0,1 % en poids de sulfate de baryum.

2. Supraconducteur haute température selon la revendication 1, caractérisé en ce que $a = 0$ ; $b + c = 0,25$ ; $d = 0$ et $x = 7,9$ à $8,5$ et en ce que le rapport Sr : Ca est de $2,2 : 1$ à $1,5 : 1$.

3. Supraconducteur haute température selon la revendication 1 ou 2, caractérisé en ce que sa teneur en sulfate strontium est au maximum de 30 % en poids et comprise de préférence entre 3 et 10 % en poids.

4. Supraconducteur haute température selon au moins une des revendications 1 à 3, caractérisé en ce que sa teneur en sulfate de baryum est au maximum de 20 % en poids et comprise de préférence entre 3 et 10 % en poids.

5. Procédé de fabrication du supraconducteur haute température selon au moins une des revendications 1 à 4, caractérisé en ce qu'on mélange intimement les oxydes de bismuth, de strontium, de calcium et de cuivre et le cas échéant de plomb avec les sulfates de strontium et/ou de baryum, qu'on fait fondre le mélange par chauffage à des températures de 870 à 1 300°C, de préférence de 900 à 1 100°C, des teneurs supérieures en sulfates de strontium et/ou de baryum exigeant des températures supérieures, qu'on coule la masse fondue dans des coquilles et qu'on l'y laisse se solidifier lentement et qu'on recuit les corps moulés démoulés des coquilles à des températures de 700 à 900°C, de préférence de 750 à 870°C, dans une atmosphère contenant de l'oxygène.

**6.** Procédé selon la revendication 5, caractérisé en ce qu'on coule la masse fondue dans un cylindre horizontal, tournant autour de son axe longitudinal.

**7.** Procédé selon la revendication 5 ou 6, caractérisé en ce qu'on coule la masse fondue dans des coquilles en quartz.

**8.** Procédé selon la revendication 5 ou 6, caractérisé en ce qu'on coule la masse fondue dans des coquilles en cuivre.

**9.** Procédé selon au moins une des revendications 5 à 8, caractérisé en ce que pour le traitement de recuit on chauffe rapidement les corps moulés jusqu'à 700°C à raison de 250 à 350°C/h et lentement au-delà à raison de 5 à 20°C/h.

**10.** Procédé selon au moins une des revendications 5 à 9, caractérisé en ce qu'on procède au recuit dans une atmosphère d'air et d'azote dans un rapport volumique de 1 : 1.

**11.** Procédé selon au moins une des revendications 5 à 9, caractérisé en ce qu'on procède au recuit dans de l'oxygène pur.

**Revendications pour l'Etat contractant suivant : ES**

**1.** Procéde de fabrication d'un supraconducteur haute température composé d'oxydes de bismuth, de strontium, de calcium et de cuivre et le cas échéant de plomb, de composition $Bi_{2-a+b+c} Pb_a$ (Sr, Ca)-$_{3-b-c} Cu_{2+d} O_x$ où a = 0 à 0,7 ; b + c = 0 à 0,5 ; d = -0,1 à 0,1 ; x = 7 à 10 et le rapport Sr ; Ca est de 2,8 : 1 à 1 : 2,8 caractérisé en ce qu'on mélange intimement les oxydes de bismuth, de strontium, de calcium et de cuivre et le cas échéant de plomb avec une quantité de sulfates de strontium et/ou de baryum telle que le supraconducteur haute température obtenu contient au moins 0,1 % en poids de sulfate de strontium et/ou au moins 0,1 % en poids de sulfate de baryum qu'on fait fondre le mélange par chauffage à des températures de 870°C à 1 300°C, de préférence de 900 à 1 100°C, des teneurs supérieures en sulfates de strontium et/ou de baryum exigeant des températures supérieures, qu'on coule la masse fondue dans des coquilles et qu'on l'y laisse se solidifier lentement et qu'on recuit les corps moulés démoulés des coquilles à des températures de 700 à 900°C, de préférence de 750 à 870°C dans une atmosphère contenant de l'oxygène.

**2.** Procéde selon la revendication 1, caractérisé en ce que la teneur en sulfate de strontium du supraconducteur haute température est au maximum de 30 % en poids et comprise de préférence entre 3 et 10 % en poids.

**3.** Procéde selon la revendication 1 ou 2, caractérisé en ce que la teneur en sulfate de baryum du supraconducteur haute température est au maximum de 20 % en poids et comprise de préférence entre 3 et 10 % en poids.

**4.** Procédé selon au moins une des revendications 1 à 3, caractérisé en ce qu'on coule la masse fondue dans un cylindre horizontal, tournant autour de son axe longitudinal.

**5.** Procédé selon au moins une des revendications 1 à 3, caractérisé en ce qu'on coule la masse fondue dans des coquilles en quartz.

**6.** Procédé selon au moins une des revendications 1 à 3, caractérisé en ce qu'on coule la masse fondue dans des coquilles en cuivre.

**7.** Procédé selon au moins une des revendications 1 à 6, caractérisé en ce que pour le traitement de recuit on chauffe rapidement les corps moulés jusqu'à 700°C à raison de 250 à 350°C/h, et lentement au-delà à raison de 5 à 20°C/h.

**8.** Procédé selon au moins une des revendications 1 à 7, caractérisé en ce qu'on procède au recuit dans une atmosphère d'air et d'azote dans un rapport volumique de 1 : 1.

9. Procédé selon au moins un des revendications 1 à 7, caractérisé en ce qu'on procède au recuit dans de l'oxygène pur.